# EUROPÄISCHE PATENTSCHRIFT

(11) **EP 0 987 801 B1**
(45) Veröffentlichungstag und Bekanntmachung des Hinweises auf die Patenterteilung: **31.07.2002**
(21) Anmeldenummer: 99118259.3
(22) Anmeldetag: 14.09.1999
(51) Int. Cl.: H01S 5/02, G02B 6/42

(54) **Verfahren zur Herstellung eines optoelektronischen Bauelements**
Process of manufacturing an optoelectronic semiconductor device
Procédé de fabrication d'un composant semi-conducteur optoélectronique

(30) Priorität: 14.09.1998 DE 19842038
(43) Veröffentlichungstag der Anmeldung: 22.03.2000
(73) Patentinhaber: Infineon Technologies AG, 81669 München (DE)
(72) Erfinder: Auracher, Franz, Dr., 82065 Baiersbrunn (DE); Gramann, Wolfgang, 93053 Regensburg (DE)
(74) Vertreter: Lange, Thomas, Dr.

(56) Entgegenhaltungen:
- EP-A- 0 356 331
- EP-A- 0 660 467
- DE-C- 19 704 502
- FR-A- 2 730 823
- PATENT ABSTRACTS OF JAPAN vol. 011, no. 014 (M-553), 14. Januar 1987 (1987-01-14) & JP 61 189965 A (OKI ELECTRIC IND CO LTD), 23. August 1986 (1986-08-23)

## Beschreibung

Die Erfindung betrifft ein Verfahren zur Herstellung eines optoelektronischen Bauelements mit einem Laserchip als Lichtsender und einer Linsenkoppeloptik zum definierten Abstrahlen der im Laserchip erzeugten Strahlung.

Derartige optoelektronische Bauelemente werden insbesondere in der optischen Daten- und Nachrichtentechnik als Lichtsendebauelemente zur Einkopplung des erzeugten Laserlichts in einen Lichtwellenleiter verwendet.

In der EP 0 660 467 B1 ist ein optoelektronisches Bauelement beschrieben, das einen Si-Träger verwendet, auf dem der Laserchip angebracht ist. Das von dem Laserchip parallel zu der Oberfläche des Si-Trägers emittierte Laserlicht fällt in eine Linsenkoppeloptik und wird von dieser um 90° umgelenkt und fokussiert. Die Linsenkoppeloptik weist ein auf dem Träger angebrachtes Umlenkprisma und einen im Strahlengang hinter dem Umlenkprisma vorhandenen Linsenchip auf.

Die Herstellung dieser optoelektronischen Bauelemente erfolgt im Scheibenverbund. Zunächst wird eine als gemeinsamer Träger dienende Si-Scheibe mit geeigneten metallischen Oberflächenstrukturen versehen. Danach werden untereinander beabstandete, parallele Vertiefungen in die Si-Scheibe eingeätzt. In diese Vertiefungen werden Prismenstreifen mit trapezförmigem Profil eingebracht und anodisch oder durch Löttechnik gebondet. Danach werden die Laserchips in einem definierten Abstand von den Prismenstreifen auf der Si-Scheibe angeordnet und befestigt. Die Vereinzelung in separate Bauelemente erfolgt vor oder nach der Anbringung der Laserchips durch Zersägen der Si-Scheibe entlang quer zu den Prismenstreifen verlaufenden Trennlinien. Schließlich werden auf den durch das Zersägen erzeugten einzelnen Umlenkprismen die Linsenchips befestigt.

Dieses Verfahren weist den Nachteil auf, daß die Gegenstandsweite der optischen Abbildung, d.h. die Länge des Lichtwegs zwischen der emittierenden Laserkante und der Hauptebene der Linse, nicht immer mit der benötigten Genauigkeit einstellbar ist. Bei einem konstruktiv vorgegebenen, festen Abstand zwischen Linse und Umlenkprisma wird die Gegenstandsweite durch den Abstand zwischen dem Laserchip und dem Prismenstreifen bestimmt. In der Praxis hat sich gezeigt, daß dieser Abstand mit den derzeit verfügbaren Positionieranlagen nicht immer mit ausreichender Genauigkeit voreinstellbar ist. Darüber hinaus treten herstellungsbedingte Variationen der Brennweiten der Linsen auf. Um die unvermeidlichen Lagefehler der Laserchips auszugleichen, müssen deshalb nach dem Positionierschritt sowohl die Abstände zwischen den Laserchips und den Umlenkprismen als auch die Brennweiten der zu verwendenden Linsen einzeln vermessen werden und dann jeweils eine passende Linse dem jeweiligen Laserchip zugeordnet werden, um die gewünschte Fokussierung des Laserstrahls in einer vorgegebenen Bildebene zu erzielen.

Der Erfindung liegt die Aufgabe zugrunde, ein Verfahren zur Herstellung eines optoelektronischen Bauelements mit einem Laserchip und einer den Laserstrahl umlenkenden Linsenkoppeloptik anzugeben, das eine kostengünstige Herstellung von derartigen Bauelementen ermöglicht.

Die der Erfindung zugrundeliegende Aufgabe wird durch Verfahren gemäß den Ansprüchen 1 und 2 gelöst. Weitere Ausgestaltungen der Erfindung werden in den Ansprüchen 3 bis 6 definiert.

Bei beiden erfindungsgemäßen Verfahren wird zunächst der Laserchip auf der Halbleiterscheibe durch Löten lagemäßig festgelegt. Die Einstellung der gewünschten Gegenstandsweite erfolgt dann durch eine entsprechende Justage der Linsenkoppeloptik. Zu diesem Zweck wird der Laserchip betrieben und die Linsenkoppeloptik auf der Halbleiterscheibe gezielt verschoben, bis eine vorgegebene Strahlbedingung hinsichtlich der Lage der Brennebene der optischen Abbildung erfüllt ist.

Auf diese Weise kann die gewünschte fokale Justage des optoelektronischen Bauelements ohne ein Vermessen des Abstands zwischen Laserchip und Umlenkprisma sowie der Brennweiten der zu verwendenden Linsen durchgeführt werden. Ein weiterer wesentlicher Vorteil des erfindungsgemäßen Verfahrens besteht darin, daß vorgefertigte Linsenkoppeloptiken eingesetzt werden können.

Die vorgegebene Strahlbedingung kann beispielsweise darin bestehen, daß der die Linsenkoppeloptik verlassende Laserstrahl kollimiert ist oder in einer unter einem vorgegebenen Abstand von der Oberfläche der Halbleiterscheibe liegenden Bildebene fokussiert ist.

Wenn die gewünschte Position der Linsenkoppeloptik relativ zu dem Laserchip gefunden ist, wird die Linsenkoppeloptik auf der Halbleiterscheibe bzw. einem Teilstück derselben durch Löten befestigt. Das optoelektronische Bauelement ist dann betriebsfertig.

Die Auftrennung der Halbleiterscheibe in einzelne Teilstücke (Träger) mit jeweiligem Laserchip kann zeitlich vor der Justage (Verfahrensschritte c bis f) der Linsenkoppeloptiken erfolgen. Es ist aber auch möglich, die genannten Justageschritte bezüglich jeder Linsenkoppeloptik im Scheibenverbund durchzuführen. In diesem Fall erfolgt die Vereinzelung der fertig justierten optoelektronischen Bauelemente am Schluß des Herstellungsverfahrens nach der Befestigung der Linsenkoppeloptiken (Schritt f) auf der Halbleiterscheibe.

Ein erster Aspekt der Erfindung gemäß Anspruch 1 besteht darin, daß vor dem Aufbringen der metallischen Strukturen eine Wärmeisolationsschicht, insbesondere SiO₂-Schicht auf die Halbleiterscheibe aufgebracht und zumindest an den für die Laserchips vorgesehenen Positionen bereichsweise wieder entfernt. Die Wärmeisolationsschicht reduziert die Wärmeleitung von der erwärmten Linsenkoppeloptik zu dem Laserchip und wirkt daher einer Entlötung desselben entgegen. Da unterhalb des Laserchips keine Wärmeisolationsschicht vorhanden ist, ist weiterhin eine gute thermische Ankopplung des Laserchips an die Halbleiterscheibe sichergestellt.

Ein zweiter Aspekt der Erfindung gemäß Anspruch 2 besteht darin, daß bei dem Lötschritt zur Befestigung der Linsenkoppeloptik eine Lötbeschichtung verwendet wird, die eine niedrigere Schmelztemperatur als eine für die Befestigung des Laserchips verwendete Lötbeschichtung aufweist. Auch durch diese Maßnahme wird einer Entlötung des Laserchips beim späteren Verlöten der Linsenkoppeloptik vorgebeugt.

Eine zweckmäßige Realisierungsmöglichkeit der erfindungsgemäßen Verfahren besteht darin, daß bei dem Lötschritt zur Befestigung der Linsenkoppeloptik die Wärme lokal zugeführt wird. Die lokale Wärmeapplikation kann beispielsweise mittels eines Laserstrahls erfolgen.

Weitere erfindungsgemäß besonders bevorzugte Maßnahmen beziehen sich auf die Herstellung der verwendeten Linsenkoppeloptik.

Gemäß einer ersten bevorzugten Herstellungsvariante werden an einer Oberfläche eines Linsenträgersubstrats zeilenweise nebeneinanderliegend angeordnete Linsen ausgebildet, wobei die Zeilen unter einem vorgegebenen Zeilenabstand voneinander beabstandet sind. Unabhängig davon werden in einem Umlenkprismensubstrat unter dem (gleichen) Zeilenabstand angeordnete, parallel verlaufende Nuten eingebracht, und eine Seitenlängsfläche der Nuten zumindest teilflächig verspiegelt. Danach werden das Linsenträgersubstrat und das Umlenkprismensubstrat an ihren linsenabgewandten und nutenzugewandten Oberflächen lagerichtig zusammengefügt und der dabei gebildete Verbund aus Linsenträgersubstrat und Umlenkprismensubstrat gemeinsam in die einzelnen Linsenkoppeloptiken aufgetrennt.

Die Linsenkoppeloptiken können auch aus einem einzigen, sowohl als Linsenträger als auch als Umlenkprismenträger wirkenden Substrat hergestellt werden. In diesem Fall werden zeilenweise nebeneinanderliegend angeordnete Linsen an einer ersten Oberfläche des Substrats ausgebildet, und an einer der ersten Oberfläche gegenüberliegenden zweiten Oberfläche parallel verlaufende Nuten eingebracht. Die Zeilen und die Nuten sind jeweils unter einem gleichen Abstand angeordnet und weisen eine vorgegebene, feste Relativlage zueinander auf. Eine Seitenlängsfläche jeder Nute wird zumindest teilflächig verspiegelt, und das Substrat nachfolgend in die einzelnen Linsenkoppeloptiken aufgetrennt.

Wenn das Linsenträgersubstrat bzw. das Substrat aus einem einkristallinen Material wie beispielsweise Silizium besteht, können die Nuten vorzugsweise durch einen einfachen, kostengünstig durchführbaren anisotropen Ätzvorgang bezüglich einer kristallographischen Orientierung des einkristallinen Materials in dieses eingebracht werden.

Weitere bevorzugte Ausführungsvarianten des erfindungsgemäßen Verfahrens sind in der Beschreibung angegeben.

Die Erfindung wird nachfolgend anhand verschiedener Ausführungsvarianten unter Bezugnahme auf die Zeichnung näher erläutert; in dieser zeigt:
- Fig. 1: eine schematische Schnittdarstellung eines optoelektronischen Bauelements mit einfacher Strahlumlenkung;
- Fig. 2: eine schematische Schnittdarstellung eines optoelektronischen Bauelements mit zweifacher Strahlumlenkung;
- Fig. 3a: eine schematische Schnittdarstellung eines Umlenkprismensubstrats mit teilflächig verspiegelten Nuten;
- Fig. 3b: das in Fig. 3a gezeigte Umlenkprismensubstrat in Draufsicht;
- Fig. 4a: eine schematische Schnittdarstellung eines Linsenträgersubstrat mit eingebrachten Nuten;
- Fig. 4b: das in Fig. 4a gezeigte Linsenträgersubstrat nach dem Herausbilden der Linsenkörper; und
- Fig. 4c: eine schematische Schnittdarstellung eines optoelektronischen Bauelements, das eine gemäß den Fig. 4a und 4b hergestellte Linsenkoppeloptik verwendet.

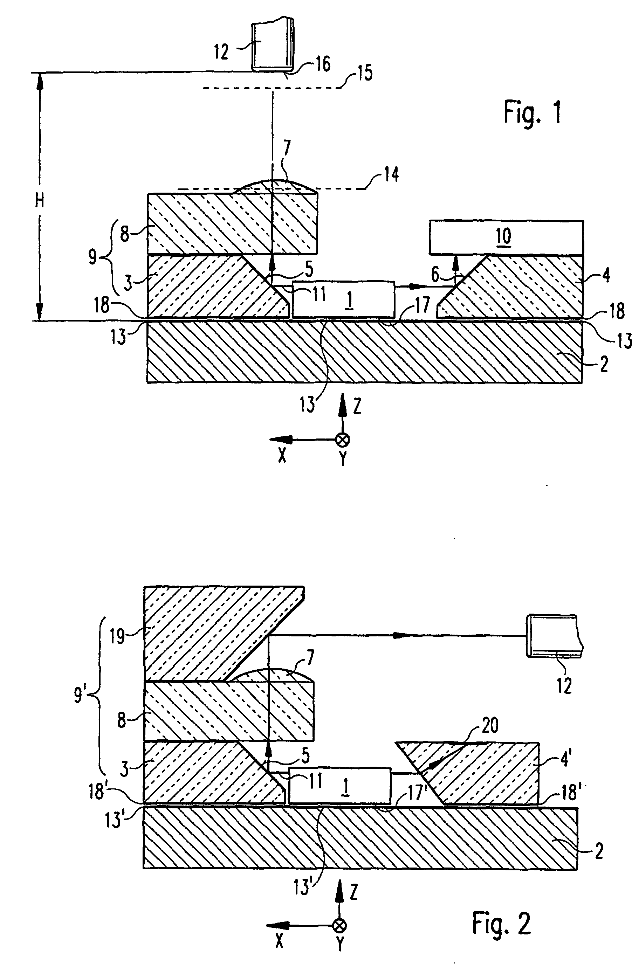

Das in Fig. 1 dargestellte optoelektronische Bauelement weist als Lichtsender einen Laserchip 1 auf, der auf einem vorzugsweise aus Silizium bestehenden Träger 2 (Silizium-Submount) angeordnet ist. Zwischen dem Träger 2 und dem Laserchip 1 befindet sich eine beispielsweise aus Au bestehende Metallschicht 13, die der bodenseitigen elektrischen Kontaktierung des Laserchips 1 dient.

Der Träger 2 trägt ferner zwei Umlenkprismen 3, 4, die zu beiden Seiten des Laserchips 1 angeordnet sind. Die Umlenkprismen 3, 4 bestehen vorzugsweise aus Glas und weisen jeweils eine dem Laserchip 1 zugewandte Spiegelfläche 5, 6 auf. Beide Spiegelflächen 5, 6 sind unter einem Winkel von 45° gegenüber der aktiven Zone des Laserchips 1 orientiert. Auf dem einen Umlenkprisma 3 ist eine vorzugsweise in einem Linsenchip 8 integrierte Linse 7 befestigt.

Von dem Laserchip 1 an seiner Vorderseite in x-Richtung emittiertes Laserlicht 11 wird an der Spiegelfläche 5 des ersten Umlenkprismas 3 unter einem Winkel von 90° in z-Richtung umgelenkt und durchläuft die Linse 7 des Linsenchips 8.

Das erste Umlenkprisma 3 und der Linsenchip 8 mit Linse 7 bilden zusammen eine Linsenkoppeloptik 9 aus, mittels der das emittierte Laserlicht 11 in einen Lichtwellenleiter 12 eingekoppelt wird, der unter vorgegebener Höhe H über dem Träger 2 an einem nicht dargestellten Gehäuse festgelegt, in welches das optoelektronische Bauelement eingebaut ist.

Auf dem zweiten Umlenkprisma 4 ist ein Monitor-Chip 10 angeordnet. Der Monitor-Chip 10 empfängt Laserlicht, das den Laserchip 1 an seiner Rückseite verläßt und an der Spiegelfläche 6 des zweiten Umlenkprismas 4 umgelenkt wird. Der Monitor-Chip 10 kann zur Messung bzw. Regelung der Laserleistung verwendet werden.

Im folgenden wir ein erfindungsgemäßes Verfahren zur Herstellung eines solchen optoelektronischen Bauelements beschrieben:

Zunächst werden in nicht dargestellter Weise auf einer Halbleiterscheibe, insbesondere Si-Scheibe periodische metallische Strukturen (Leiterbahnen, Bondpads) aufgebracht. Die metallischen Strukturen bilden (nach der Vereinzelung) die Metallschicht 13 zur bodenseitigen Kontaktierung der Laserchips 1.

Nachfolgend wird die Halbleiterscheibe mit den Laserchips 1 bestückt. Zu diesem Zweck sind die Laserchips 1 an ihrer der Halbleiterscheibe zugewandten Unterseite mit einer Lötbeschichtung 17 aus AuSn, AuGe, AuSi, PbSn oder anderen lötfähigen Schichten von etwa 1 bis 10 µm Dicke versehen und werden unter einem durch die Periodizität der metallischen Struktur vorgegebenen Abstand auf diese aufgelötet.

In einem nächsten Schritt des Herstellungsverfahrens werden die auf der Halbleiterscheibe montierten Laserchips 1 einer gemeinsamen Funktionsprüfung ("burn-in") unterzogen. Diese Prüfung wird unter Hochstrombedingungen durchgeführt, um in vertretbarer Zeit eine Lebensdauerabsicherung der einzelnen Laserchips 1 zu erhalten.

Nach der Funktionsprüfung wird die Halbleiterscheibe auf eine adhäsive Folie aufgezogen und durch Zersägen oder Brechen in die in Fig. 1 dargestellten Träger 2 mit aufgelöteten Laserchips 1 aufgetrennt. Die bei der Funktionsprüfung als untauglich erkannten Träger 2 mit Laserchips 1 werden ausgesondert.

Nachfolgend erfolgt die Montage der Linsenkoppeloptiken 9 auf den einzelnen Trägern 2. Hierbei werden jeweils die folgenden Justageschritte ausgeführt:

Der Laserchip 1 wird betrieben und emittiert parallel zu der Oberfläche des Trägers 2 (d.h. in x-Richtung) verlaufendes Laserlicht 11. Die Gegenstandsweite der optischen Abbildung, d.h. die Summe der Abstände zwischen der emittierenden Laserchipkante und der Spiegelfläche 5 sowie der Spiegelfläche 5 und der Hauptebene 14 der Linse 7 kann nun durch Verschieben der Linsenkoppeloptik 9 in x-Richtung auf dem Träger 2 variiert werden. Dabei bestimmt die eingestellte Gegenstandsweite die Bildweite, die als der Abstand zwischen der Hauptebene 14 der Linse 7 und der Bildebene 15 definiert ist. In dem hier dargestellten Beispiel soll das Laserlicht auf eine Endfläche 16 des Lichtwellenleiters 12 fokussiert werden. Die Justagebedingung besteht dann darin, daß der Abstand der verschiebbaren Linsenkoppeloptik 9 relativ zu dem trägerfesten Laserchip 1 so variiert und eingestellt wird, daß die Bildebene 15 der optischen Abbildung mit der Ebene der Endfläche 16 des Lichtwellenleiters 12 zusammenfällt.

Alternativ kann die Justagebedingung beispielsweise auch darin bestehen, daß im Strahlengang hinter der Linse ein kollimierter Laserstrahl gefordert ist. In diesem Fall wird die Gegenstandsweite so eingestellt, daß die Bildebene 15 im Unendlichen liegt. Die Gegenstandsweite entspricht dann der Brennweite der Linse 7.

Durch ein Verschieben der Linsenkoppeloptik in y-Richtung auf dem Träger 2 kann die Strahlrichtung in der zy-Ebene beeinflußt werden. Auf diese Weise kann der fokussierte Strahl bezüglich der y-Richtung mittig auf die Endfläche 16 des Lichtwellenleiters 12 positioniert werden. Eine Beeinflussung der im zuvor beschrieben Justageschritt eingestellten Strahlfokussierung ist auf diese Weise jedoch nicht erreichbar.

Die Linsenkoppeloptik 9 wird dann in der fertig justierten Stellung mittels Laserlötens an der auf dem Träger 2 angebrachten Au-Metallschicht befestigt. Hierfür ist die Unterseite des Umlenkprismas 3 mit einer Lötbeschichtung 18 versehen, die aus dem gleichen Material wie die Lötbeschichtung 17 an dem Laserchip 1 bestehen kann. Der zur Wärmezufuhr verwendete Laserstrahl wird gezielt auf die Linsenkoppeloptik 9 gerichtet, wobei die thermische Belastung das Laserchips 1 vergleichsweise gering gehalten werden kann, d.h. eine Entlötung desselben ausgeschlossen ist.

In nicht dargestellter Weise kann im Bereich unterhalb der Linsenkoppeloptik 9 eine zwischen dem Träger 2 und der Au-Metallschicht 13 verlaufende, beispielsweise aus SiO₂ bestehende Wärmeisolationsschicht vorgesehen sein.

Die Verbindung zwischen dem ersten Umlenkprisma 3 und dem Linsenchip 8 muß beim Laserlöten stabil bleiben. Sie ist aus diesem Grund beispielsweise durch anodisches Bonden realisiert.

Schließlich wird die aus dem zweiten Umlenkprisma 4 und dem Monitor-Chip 10 bestehende Einheit an dem Träger 2 ebenfalls durch Laserlöten befestigt. Hierfür weist das zweite Umlenkprisma 4 an seiner Unterseite beispielsweise die gleiche Lötbeschichtung 18 wie das erste Umlenkprisma 3 auf. Die gegebenenfalls vorhandene SiO₂-Wärmeisolationsschicht erstreckt sich auch unterhalb des zweiten Umlenkprismas 4.

Fig. 2 dient zur Erläuterung einer Verfahrensvariante anhand eines weiteren optoelektronischen Bauelement, bei dem entsprechende Teile wie in Fig. 1 mit den gleichen Bezugszeichen bezeichnet sind.

Das in Fig. 2 dargestellte Bauelement unterscheidet sich von dem in Fig. 1 gezeigten Bauelement im wesentlichen durch die Verwendung einer anderen Metallisierungsfolge 13', 17', 18' des Trägers 2, des Laserchips 1 und der Umlenkprismen 3, 4'. Ferner weist die hier verwendete Linsenkoppeloptik 9' ein weiteres Umlenkprisma 19 zur zweifachen Strahlumlenkung auf und es wird ein zweites Umlenkprisma 4' mit integriertem Photoelement 20 als Monitor-Chip verwendet.

Die Metallschicht 13' des Trägers 2 und die Lötbeschichtungen 18' der Umlenkprismen 3, 4' bestehen hier aus AuSn. Demgegenüber ist der Lötbeschichtung 17' an der Unterseite des Laserchips 1 Au zulegiert, wodurch sich ihre Schmelztemperatur erhöht. Folglich wird eine Abstufung der Löttemperaturen für die zunächst erfolgende Verlötung des Laserchips 1 und die nachfolgende Verlötung der Linsenkoppeloptik 9' und des zweiten Umlenkprismas 4' mit integriertem Photoelement 20 erzielt. Dies ermöglicht, daß die Verlötung der Linsenkoppeloptik 9' und des zweiten Umlenkprismas 4' bei einer niedrigeren Löttemperatur als die Verlötung des Laserchips 1 durchgeführt werden kann. Damit wird auch ohne Anwendung einer lokalen Wärmezufuhrtechnik die Gefahr einer Entlötung des Laserchips 1 ausgeschaltet. Die Verlötung der Linsenkoppeloptik 9' und des Umlenkprismas 4' kann gemeinsam in einem Prozeßschritt durchgeführt werden.

Die beiden beschriebenen Verfahrensvarianten (lokale Wärmezufuhr und Abstufung der Löttemperaturen) können kombiniert werden.

Die Justage der Linsenkoppeloptik 9' mit zweifacher Strahlumlenkung erfolgt gemäß dem anhand Fig. 1 erläuterten Justageablauf.

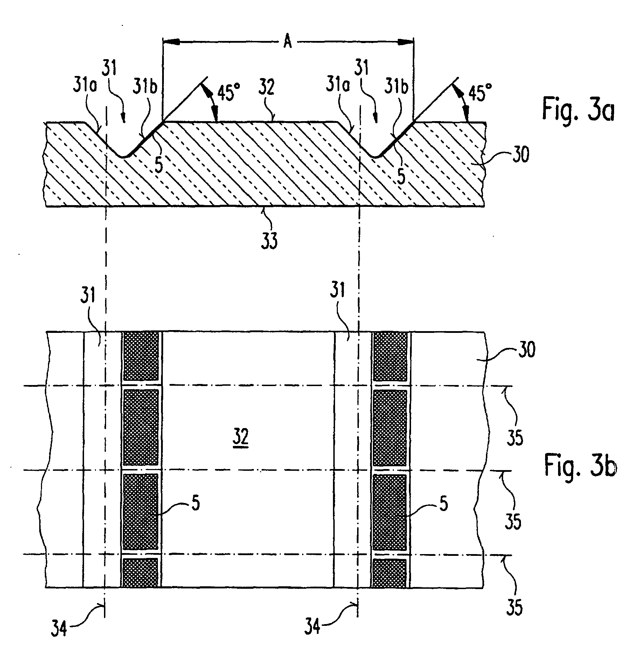

Zur Herstellung der Vielzahl von Linsenkoppeloptiken 9, 9' werden nach den Fig. 3a und 3b in ein beispielsweise aus Glas bestehendes Umlenkprismensubstrat 30 parallel verlaufende, V-förmige Nuten 31 eingebracht. Die Nuten 31 sind unter einem äquidistanten Abstand A an einer ersten Oberfläche 32 des Umlenkprismensubstrats 30 angeordnet.

Die Nuten 31 weisen jeweils zwei Längsseitenflächen 31a, 31b auf. Zumindest die Längsseitenfläche 31b ist unter einem Winkel von 45° gegenüber der ersten Oberfläche 32 des Umlenkprismensubstrats 30 geneigt.

Die Längsseitenflächen 31b der Nuten 31 werden mit Spiegelschichten 5 (siehe Fig. 1 und 2) versehen.

An einer Oberfläche eines (nicht dargestellten) Linsenträgersubstrats werden in üblicher Weise zeilenweise nebeneinanderliegend angeordnete Linsen 7 ausgebildet. Der Zeilenabstand ist mit dem Abstand A der Nuten 31 in dem Umlenkprismensubstrat 30 identisch.

In einem nächsten Schritt wird das Linsenträgersubstrat mit seiner ebenen, linsenfernen Oberfläche auf die Oberfläche 32 des Umlenkprismensubstrats 30 aufgelegt und so ausgerichtet, daß die Nuten 31 parallel zu den Linsenzeilen verlaufen.

Danach wird das Linsenträgersubstrat in Querrichtung zu dem Linsen/Nutenverlauf bezüglich dem Umlenkprismensubstrat 30 in geeigneter Weise verschoben. Bei diesem Justageprozeß wird die in den Linsenkoppeloptiken 9, 9' auftretende Strahlrichtung in der zx-Ebene festgelegt. Die Justage wird vorzugsweise so durchgeführt, daß der emittierte Laserstrahl 11 bei Reflexion an der Spiegelschicht 5 jeweils achsmittig durch die Linse 7 hindurchläuft. Auch dieser Justageschritt beeinflußt lediglich die Strahlrichtung und nicht die Lage der Bildebene 15 der optischen Abbildung.

Nach der Justage werden das Linsenträgersubstrat und das Umlenkprismensubstrat 30 mittels eines anodischen Bondprozesses miteinander verbunden. Falls beim Verspiegeln der Nuten 31 auch die zum anodischen Bonden vorgesehene Oberfläche 32 des Umlenkprismensubstrats 30 beschichtet wurde, muß vor dem Bonden die unerwünschte Beschichtung durch leichtes Überschleifen oder Polieren entfernt werden.

Nach dem Bondprozeß wird der Verbund aus Umlenkprismensubstrat 30 und (nicht dargestelltem) Linsenträgersubstrat an der nutenfernen Oberfläche 33 des Umlenkprismensubstrats 30 auf die gewünschte Dicke geschliffen und im Anschluß daran auf eine adhäsive Folie aufgezogen und entlang der Trennlinien 34 und 35 in Längs- bzw. Querrichtung zersägt. Dabei werden die in Fig. 1 dargestellten einzelnen Linsenkoppeloptiken 9 erhalten.

Zur Herstellung der Linsenkoppeloptiken 9' mit zweifacher Strahlumlenkung kann in analoger Weise unter Verwendung eines weiteren Umlenkprismensubstrats vorgegangen werden.

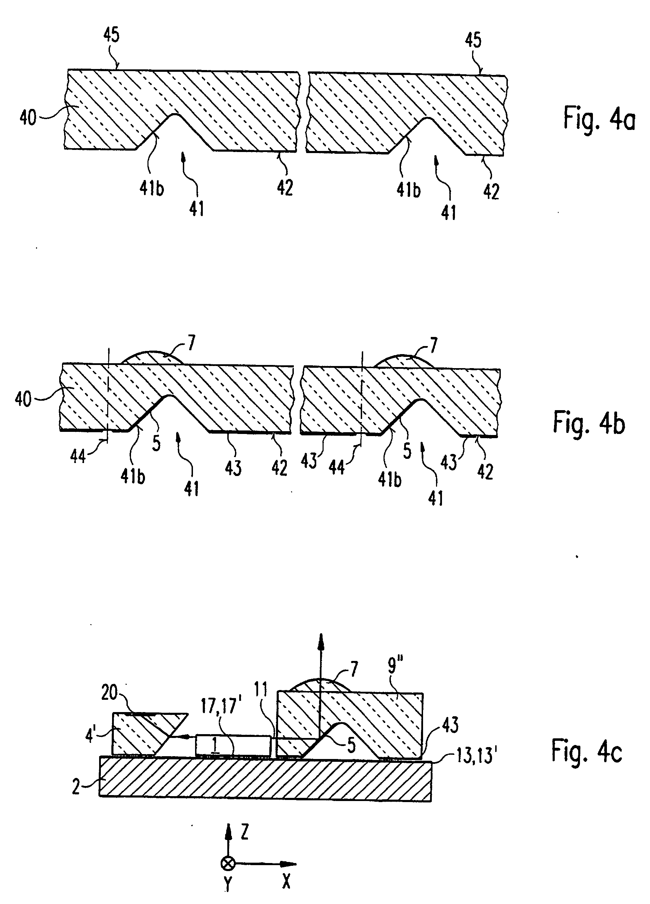

Die Fig. 4a bis 4c verdeutlichen eine Verfahrensvariante zur Herstellung einer weiteren Linsenkoppeloptik 9''. In einem gleichzeitig als Linsen- und Umlenkprismenträger verwendeten Substrat 40, das beispielsweise aus Glas oder Si besteht, werden gemäß der Beschreibung zu Fig. 3a an einer Unterseite 42 parallel verlaufende Nuten 41 eingebracht und an einer Längsseitenfläche 41b verspiegelt. An einer Oberseite 45 des Substrats 40 werden sodann unter Berücksichtigung der erwähnten Lagebeziehung (Fig. 3a, 3b) zeilenweise nebeneinanderliegend angeordnete Linsen 7 herausgebildet (siehe Fig. 4b).

Anschließend wird das Substrat 40 an seiner Unterseite 42 mit einer den Lötbeschichtungen 18 bzw. 18' entsprechenden Lötbeschichtung 43 versehen, auf eine adhäsive Folie aufgezogen und entlang der Trennlinien 44 sowie entlang nicht dargestellter querverlaufender Trennlinien (entsprechend den Trennlinien 35) in einzelne Linsenkoppeloptiken 9'' zerteilt.

Fig. 4c zeigt ein optoelektronisches Bauelement, das die Linsenkoppeloptik 9'' verwendet. Bezüglich der vorhergehenden Figuren entsprechende Teile sind wiederum mit den gleichen Bezugszeichen versehen. Die Linsenkoppeloptik 9'' ist in der bereits beschriebenen Weise gegenüber dem Laserchip 1 justiert und mit dem Träger 2 verlötet. Als Monitor-Chip wird wiederum das Umlenkprisma 4' mit integriertem Photoelement 20 verwendet. Diese Ausführungsform eignet sich insbesondere dazu, daß der Spalt zwischen der Laserdiode 1 und der Stirnfläche der Linsenkoppeloptik 9'' mit einer Vergußmasse ausgefüllt wird, um den Laserchip 1 vor Umwelteinflüssen zu schützen, wenn das optoelektronische Bauelement nicht in ein hermetisch dichtes Gehäuse eingebaut wird.

## Patentansprüche

1. Verfahren zur Herstellung eines optoelektronischen Bauelements mit einem Laserchip (1) als Lichtsender und einer Linsenkoppeloptik (9, 9', 9'') zum definierten Abstrahlen der im Laserchip (1) erzeugten optischen Strahlung (11), bei dem:
a1) auf eine Halbleiterscheibe (2) eine Wärmeisolationsschicht, insbesondere SiO₂-Schicht aufgebracht wird, und die Wärmeisolationsschicht zumindest an den für die Laserchips (1) vorgesehenen Positionen bereichsweise wieder entfernt wird,
a2) die Halbleiterscheibe (2) mit metallischen Strukturen (13, 13') zur elektrischen Kontaktierung und mechanischen Befestigung von einer Mehrzahl von Laserchips (1) versehen wird,
b) die Laserchips (1) mit im wesentlichen parallel zu der Halbleiterscheibe (2) orientiertem Strahlengang durch Löten auf den metallischen Strukturen (13, 13') befestigt werden,
c) zu jedem Laserchip (1) eine den Strahlengang des zugehörigen Laserchips (1) umlenkende Linsenkoppeloptik (9, 9' 9'') auf der Halbleiterscheibe oder einem durch Zerteilen der Halbleiterscheibe erhaltenen Teilstück (2) derselben positioniert wird,
d) der Laserchip (1) betrieben wird,
e) der Abstand zwischen dem Laserchip (1) und der Linsenkoppeloptik (9, 9', 9'') variiert und so eingestellt wird, daß das die Linsenkoppeloptik (9, 9', 9'') verlassende, umgelenkte Laserlicht (11) eine vorgegeben Strahlbedingung hinsichtlich der Lage der optischen Bildebene (15) erfüllt, und
f) die Linsenkoppeloptik (9, 9', 9'') in der eingestellten Position auf der Halbleiterscheibe oder dem Teilstück (2) derselben durch Löten befestigt wird.

2. Verfahren zur Herstellung eines optoelektronischen Bauelements mit einem Laserchip (1) als Lichtsender und einer Linsenkoppeloptik (9, 9', 9'') zum definierten Abstrahlen der im Laserchip (1) erzeugten optischen Strahlung (11), bei dem:
a) eine Halbleiterscheibe (2) mit metallischen Strukturen (13, 13') zur elektrischen Kontaktierung und mechanischen Befestigung von einer Mehrzahl von Laserchips (1) versehen wird,
b) die Laserchips (1) mit im wesentlichen parallel zu der Halbleiterscheibe (2) orientiertem Strahlengang durch Löten auf den metallischen Strukturen (13, 13') befestigt werden,
c) zu jedem Laserchip (1) eine den Strahlengang des zugehörigen Laserchips (1) umlenkende Linsenkoppeloptik (9, 9' 9") auf der Halbleiterscheibe oder einem durch Zerteilen der Halbleiterscheibe erhaltenen Teilstück (2) derselben positioniert wird,
d) der Laserchip (1) betrieben wird,
e) der Abstand zwischen dem Laserchip (1) und der Linsenkoppeloptik (9, 9', 9") variiert und so eingestellt wird, daß das die Linsenkoppeloptik (9, 9', 9") verlassende, umgelenkte Laserlicht (11) eine vorgegeben Strahlbedingung hinsichtlich der Lage der optischen Bildebene (15) erfüllt, und
f) die Linsenkoppeloptik (9, 9', 9'') in der eingestellten Position auf der Halbleiterscheibe oder dem Teilstück (2) derselben durch Löten befestigt wird, wobei bei dem Lötschritt zur Befestigung der Linsenkoppeloptik (9, 9', 9'') eine Lötbeschichtung (18') verwendet wird, die eine niedrigere Schmelztemperatur als eine für die Befestigung des Laserchips (1 verwendete Lötbeschichtung (17') aufweist.

3. Verfahren nach Anspruch 1 oder 2,
**dadurch gekennzeichnet,**
- **daß** bei dem Lötschritt zur Befestigung der Linsenkoppeloptik (9, 9', 9'') die Wärme lokal, insbesondere mittels eines Laserstrahls, zugeführt wird.

4. Verfahren nach einem der vorhergehenden Ansprüche,
**dadurch gekennzeichnet,**
**daß** zur Herstellung der in Schritt c) benötigten Linsenkoppeloptiken (9, 9')
- an einer Oberfläche eines Linsenträgersubstrats zeilenweise nebeneinanderliegend angeordnete Linsen (7) ausgebildet werden, wobei die Zeilen unter einem vorgegebenen Zeilenabstand (A) beabstandet sind,
- in einem Umlenkprismensubstrat (30) unter dem Zeilenabstand (A) angeordnete, parallel verlaufende Nuten (31) eingebracht werden,
- eine Seitenlängsfläche (31b) der Nuten (31) zumindest teilflächig verspiegelt wird,
- das Linsenträgersubstrat und das Umlenkprismensubstrat (30) an ihren linsenabgewandten und nutenzugewandten Oberflächen lagerichtig zusammengefügt werden, und
- der Verbund aus Linsenträgersubstrat und Umlenkprismensubstrat (30) gemeinsam in die einzelnen Linsenkoppeloptiken (9, 9') aufgetrennt wird.

5. Verfahren nach einem der Ansprüche 1 bis 3,
**dadurch gekennzeichnet,**
**daß** zur Herstellung der in Schritt c) benötigten Linsenkoppeloptiken (9'')
- an einer ersten Oberfläche (45) eines Substrats (40) zeilenweise nebeneinanderliegend angeordnete Linsen (7) ausgebildet und an einer der ersten Oberfläche (45) gegenüberliegenden zweiten Oberfläche (43) parallel verlaufende Nuten (41) eingebracht werden, wobei die Linsenzeilen und die Nuten (41) jeweils unter einem gleichen Abstand (A) und einer vorgegebenen Relativlage zueinander angeordnet sind,
- eine Seitenlängsfläche (41b) der Nuten (41) zumindest teilflächig verspiegelt wird, und
- das Substrat (40) in die einzelnen Linsenkoppeloptiken (9'') aufgetrennt wird.

6. Verfahren nach einem der Ansprüche 4 oder 5,
**dadurch gekennzeichnet,**
- **daß** das Umlenkprismensubstrat (30) oder das Substrat (40) aus einem einkristallinen Material, insbesondere Silizium besteht und die Nuten (31, 41) durch einen anisotropen Ätzvorgang bezüglich einer kristallographischen Orientierung des Materials eingebracht werden.

## Claims

1. Method for producing an optoelectronic component with a laser chip (1) as optotransmitter and a lens coupling optics (9, 9', 9'') for defined emission of the optical radiation (11) generated in the laser chip (1), in the case of which method:
a1) a thermal insulation layer, in particular an SiO₂ layer, is applied to a semiconductor wafer, and the thermal insulation layer is removed again partially at least at the positions provided for the laser chips (1),
a2) the semiconductor wafer (2) is provided with metal structures (13, 13') for making electric contact and mechanically fastening a plurality of laser chips (1),
b) the laser chips (1) are fastened to the metal structures (13, 13') by soldering with a beam path oriented substantially parallel to the semiconductor wafer (2),
c) a lens coupling optics (9, 9', 9'') deflecting the beam path of the associated laser chip (1) is positioned relative to each laser chip (1) on the semiconductor wafer or a segment (2) of the same obtained by dividing the semiconductor wafer,
d) the laser chip (1) is operated,
e) the distance between the laser chip (1) and the lens coupling optics (9, 9', 9'') is varied and set such that the deflected laser light (11) leaving the lens coupling optics (9, 9', 9") satisfies a prescribed beam condition with regard to the position of the optical image plane (15) and
f) the lens coupling optics (9, 9', 9'') is fastened by soldering in the set position on the semiconductor wafer or the segment (2) of the same.

2. Method for producing an optoelectronic component with a laser chip (1) as optotransmitter and a lens coupling optics (9, 9', 9'') for defined emission of the optical radiation (11) generated in the laser chip (1), in the case of which method:
a) a semiconductor wafer (2) is provided with metal structures (13, 13') for making electric contact and mechanically fastening a plurality of laser chips (1),
b) the laser chips (1) are fastened to the metal structures (13, 13') by soldering with a beam path oriented substantially parallel to the semiconductor wafer (2),
c) a lens coupling optics (9, 9', 9'') deflecting the beam path of the associated laser chip (1) is positioned relative to each laser chip (1) on the semiconductor wafer or a segment (2) of the same obtained by dividing the semiconductor wafer,
d) the laser chip (1) is operated,
e) the distance between the laser chip (1) and the lens coupling optics (9, 9', 9'') is varied and set such that the deflected laser light (11) leaving the lens coupling optics (9, 9', 9'') satisfies a prescribed beam condition with regard to the position of the optical image plane (15) and
f) the lens coupling optics (9, 9', 9'') is fastened by soldering in the set position on the semiconductor wafer or the segment (2) of the same, use being made during the soldering step for fastening the lens coupling optics (9, 9', 9'') of a solder coating (18') which has a lower melting temperature than a solder coating (17') used for fastening the laser chip (1).

3. Method according to Claim 1 or 2, **characterized in that**
- during the soldering step for fastening the lens coupling optics (9, 9', 9'') the heat is fed locally, in particular by means of a laser beam.

4. Method according to one of the preceding claims, **characterized in that** in order to produce the lens coupling optics (9, 9') required in step c)
- lenses (7) arranged lying in rows next to one another are constructed on a surface of a lens support substrate, the rows being spaced at a prescribed row spacing (A),
- grooves (31) running in parallel are introduced in a deflecting prism substrate (30) at the row spacing (A),
- a lateral longitudinal surface (31b) of the grooves (31) is aluminized at least partially,
- the lens support substrate and the deflecting prism substrate (30) are joined in the correct position at their surfaces averted from the lens and facing the groove, and
- the assembly of lens support substrate and deflecting prism substrate (30) is separated jointly into the individual lens coupling optics (9, 9').

5. Method according to one of Claims 1 to 3,
**characterized in that** for the purpose of producing the lens coupling optics (9'') required in step c),
- lenses (7) arranged in rows lying next to one another are constructed on a first surface (45) of a substrate (40), and grooves (41) running in parallel are introduced on a second surface (43) opposite the first surface (45), the lens rows and the grooves (41) being arranged in each case relative to one another at an identical spacing (A) and a prescribed relative position,
- a lateral longitudinal surface (41b) of the grooves (41) is aluminized at least partially, and
- the substrate (40) is separated into the individual lens coupling optics (9'').

6. Method according to one of Claims 4 or 5, **characterized in that** the deflecting prism substrate (30) or the substrate (40) consists of a monocrystalline material, in particular silicon, and the grooves (31, 41) are introduced by means of an anisotropic etching operation with reference to a crystallographic orientation of the material.

## Revendications

1. Procédé de fabrication d'un composant optoélectronique ayant une puce (1) laser comme émetteur de lumière et une optique (9, 9', 9") de couplage de lentilles pour émettre de manière définie le rayonnement (11) optique produit par la puce (1) laser, dans lequel :
a1) on dépose sur une tranche (2) semi-conductrice une couche isolante de la chaleur, notamment une couche en SiO₂, et on élimine à nouveau par parties la couche isolante de la chaleur, au moins en les positions prévues pour la puce (1) laser,
a2) on munit la tranche (2) semi-conductrice de structures (13, 13') métalliques pour établir le contact électrique et pour effectuer la fixation mécanique d'une multiplicité de puces (1) laser,
b) on fixe les puces (1) laser en ayant un trajet du faisceau orienté sensiblement parallèlement à la tranche (2) semi-conductrice sur les structures (13, 13') métalliques,
c) pour chaque puce (1) laser, on met en position une optique (9, 9', 9") de couplage de lentilles déviant le trajet du faisceau de la puce (1) laser associée sur la tranche semi-conductrice ou sur une partie (2) de celle-ci obtenue en fractionnant la tranche semi-conductrice,
d) on fait fonctionner la puce (1) laser,
e) on fait varier et on règle la distance entre la puce (1) laser et l'optique (9, 9', 9") de couplage de lentilles de façon à ce que la lumière (11) laser déviée et quittant l'optique (9, 9', 9") de couplage de lentilles satisfasse à une condition de rayonnement prescrite du point de vue de la position du plan image (15) optique, et
f) on fixe par brasage l'optique (9, 9', 9") de couplage de lentilles en la position réglée sur la tranche semi-conductrice ou sur la partie (2) de celle-ci.

2. Procédé de fabrication d'un composant optoélectronique ayant une puce (1) laser comme émetteur de lumière et une optique (9, 9', 9") de couplage de lentilles pour émettre de manière définie le rayonnement (11) optique produit par la puce laser, dans lequel :
a) on munit une tranche (2) semi-conductrice de structures (13, 13') métalliques pour établir le contact électrique et pour obtenir la fixation mécanique d'une multiplicité de puces (1) laser,
b) on fixe les puces (1) laser en ayant un trajet du faisceau orienté sensiblement parallèlement à la tranche (2) semi-conductrice sur les structures (13, 13') métalliques,
c) pour chaque puce (1) laser, on met en position une optique (9, 9', 9") de couplage de lentilles déviant le trajet du faisceau de la puce (1) laser associée sur la tranche semi-conductrice ou sur une partie (2) de celle-ci obtenue en fractionnant la tranche semi-conductrice,
d) on fait fonctionner la puce (1) laser,
e) on fait varier et on règle la distance entre la puce (1) laser et l'optique (9, 9', 9") de couplage de lentilles de façon à ce que la lumière (11) laser déviée et quittant l'optique (9, 9', 9") de couplage de lentilles satisfasse à une condition de rayonnement prescrite du point de vue de la position du plan image (15) optique, et
f) on fixe par brasage l'optique (9, 9', 9") de couplage de lentilles en la position réglée sur la tranche semi-conductrice ou sur la partie (2) de celle-ci, en utilisant pour le stade de brasage de fixation de l'optique (9, 9', 9") de couplage de lentilles un revêtement (18') de brasure qui a un point de fusion plus bas qu'un revêtement (17') de brasure utilisé pour la fixation de la puce (1) laser.

3. Procédé selon la revendication 1 ou 2, **caractérisé**
- **en ce que**, lors du stade de brasage pour la fixation de l'optique (9, 9', 9") de couplage de lentilles, on apporte de la chaleur localement, notamment au moyen d'un faisceau laser.

4. Procédé selon l'une des revendications précédentes, **caractérisé en ce que** pour la production de l'optique (9, 9') de couplage de lentilles qui est nécessaire au stade c)
- on constitue sur une surface d'un substrat porte-lentille des lentilles (7) disposées les unes à côté des autres, ligne par ligne, les lignes étant distantes les unes des autres d'un interligne (A) prescrit,
- on ménage des gorges (31) parallèles dans un substrat (30) formant prisme de déviation à l'interligne (A),
- on rend réfléchissante, au moins sur une partie de la surface, une surface (31b) longitudinale latérale des gorges (31),
- on assemble le substrat porte-lentille et le substrat (30) formant prisme de déviation d'une manière correcte en position sur la surface éloignée des lentilles et tournés vers les gorges, et
- on sépare le composite constitué du substrat porte-lentille et du substrat (30) formant prisme de déviation conjointement en les optiques (9, 9') de couplage de lentilles individuelles.

5. Procédé selon l'une des revendications 1 à 3, **caractérisé en ce que** pour la production des optiques (9") de couplage de lentilles qui sont nécessaires au stade c)
- on constitue sur une première surface (45) d'un substrat (40) des lentilles (7) disposées les unes à côté des autres, ligne par ligne, et on ménage sur une deuxième surface (43) opposée à la première surface (45) des gorges (41) s'étendant parallèlement, les lignes de lentilles et les gorges (41) étant disposées les unes par rapport aux autres respectivement à la même distance (A) et en une position relative prescrite,
- on rend réfléchissante au moins une partie de la surface d'une surface (41 b) longitudinale latérale des gorges (41), et
- on sépare le substrat (40) en les optiques (9") de couplage de lentilles individuelles.

6. Procédé selon l'une des revendications 4 ou 5, **caractérisé**
- **en ce que** le substrat (30) formant prisme de déviation ou le substrat (40) est en un matériau monocristallin, notamment en silicium, et les gorges (31, 41) sont ménagées par une opération d'attaque anisotrope par rapport à une orientation cristallographique du matériau.
